# FASCICULE DE BREVET EUROPEEN

(11) **EP 3 664 240 B1**
(45) Date de publication et mention de la délivrance du brevet: **10.03.2021**
(21) Numéro de dépôt: 19213563.0
(22) Date de dépôt: 04.12.2019
(51) Int. Cl.: H02H 7/122, H03K 17/082, H03K 17/78

(54) **DISPOSITIF DE DÉTECTION DE COURT-CIRCUIT DANS UN BRAS DE COMMUTATION**
KURZSCHLUSS-ERKENNUNGSVORRICHTUNG IN EINEM SCHALTARM
DEVICE FOR DETECTING SHORT-CIRCUIT IN A SWITCHING ARM

(30) Priorité: 05.12.2018 FR 1872390
(43) Date de publication de la demande: 10.06.2020
(73) Titulaire: ALSTOM Transport Technologies, 93400 Saint-Ouen (FR)
(72) Inventeur: ANDRIANOELISON, Florent, 65800 AUREILHAN (FR)
(74) Mandataire: Lavoix

(56) Documents cités:
- US-A1- 2006 056 212
- US-A1- 2014 112 037
- US-A1- 2017 012 555
- US-B1- 6 304 472
- US-B1- 6 330 143

## Description

La présente invention concerne un dispositif de détection de court-circuit dans un bras de commutation, le bras de commutation étant destiné à être positionné entre une première borne et une deuxième borne d'alimentation en tension.

Les onduleurs sont des dispositifs de puissance comportant généralement trois bras de commutation, chacun comportant deux commutateurs en série alimentés par une ou des sources de tension continue et étant connecté à une phase depuis le nœud entre les deux commutateurs.

Les commutateurs sont formés d'éléments semi-conducteurs et notamment de transistors de puissance.

Il est utile de détecter un éventuel court-circuit dans un bras de commutation de tels dispositifs de puissance, afin d'éviter la dégradation des composants électroniques.

Un court-circuit est détectable dans un bras de commutation notamment en mesurant les tension aux bornes des inductances parasites en série avec les éléments de commutation des transistors et en les comparant à un seuil de tension prédéfini au-delà duquel, on considère qu'il y a présence d'un court-circuit dans le bras de commutation.

Un dispositif de détection de court-circuit utilisant un tel procédé est décrit dans le document US 2017/0012555 Autres dispositifs de détection de court-circuit sont divulgués dans les documents US 2006/056212 et US 6304472.

La détection de court-circuit telle que décrite dans le document repose sur le choix judicieux d'une tension de seuil, ce qui nécessite un réglage complexe de cette tension de seuil, car différent pour chaque composant utilisé.

L'invention a pour but de proposer un dispositif de détection de court-circuit dans un bras de commutation ayant un fonctionnement très peu dépendant du composant utilisé et étant donc plus simple à réaliser.

A cet effet, l'invention a pour objet un dispositif du type précité, dans lequel le potentiel de la première borne étant propre à être supérieur au potentiel de la deuxième borne, le bras de commutation comprenant deux demi-bras de commutation supérieur et inférieur en série, le demi-bras de commutation supérieur étant relié électriquement à la première borne et le demi-bras de commutation inférieur étant relié électriquement à la deuxième borne, les demi-bras de commutation comportant chacun au moins un commutateur à semi-conducteur, chaque commutateur comprenant une électrode de commande et deux électrodes de conduction, le dispositif de détection de court-circuit comprenant pour chaque demi-bras de commutation, une paire de bornes de mesure, comprenant une troisième borne et une quatrième borne, configurées pour être connectées aux bornes d'une inductance parasite en série avec l'une des électrodes de conduction du au moins un commutateur dudit demi-bras de commutation, la quatrième borne étant destinée à être positionnée entre la troisième borne et la première borne, et une unité de traitement d'information connectée en entrée aux paires de bornes de mesure et ayant une sortie logique propre à fournir un signal indiquant la détection d'un court-circuit dans le bras de commutation, et dans lequel l'unité de traitement comporte :
- pour chaque paire de bornes de mesure, un module de détection configuré pour transmettre en sortie un signal de sortie représentatif du signe de la différence entre le potentiel de la quatrième borne et le potentiel de la troisième borne, et
- un module de comparaison propre à fournir via la sortie logique le signal indiquant la détection d'un court-circuit, seulement lorsque les signaux de sortie transmis par les deux modules de détection sont chacun représentatifs d'un signe positif.

Suivant certains modes de réalisation, le dispositif de détection de court-circuit comporte l'une ou plusieurs des caractéristiques suivantes :
- chaque module de détection comprend un optocoupleur,
- chaque optocoupleur comprend une diode électroluminescente connectée aux bornes de mesure et un capteur optique dont la sortie est propre à fournir le signal de sortie représentatif du signe de la différence entre le potentiel de la quatrième borne et le potentiel de la troisième borne,
- la diode électroluminescente est configurée pour émettre une onde lumineuse lorsque le signe de la différence entre le potentiel de la quatrième borne et le potentiel de la troisième borne est positif et chaque capteur optique comprend un phototransistor configuré pour être passant seulement lorsqu'il détecte une onde lumineuse issue de la diode électroluminescente,
- une diode est connectée tête-bêche avec la diode électroluminescente, et
- le module de comparaison est une porte logique ET.

L'invention a aussi pour objet un dispositif de puissance comportant au moins un bras de commutation,
le bras de commutation étant positionné entre une première borne et une deuxième borne d'alimentation en tension, le potentiel de la première borne étant supérieur au potentiel de la deuxième borne, le bras de commutation comprenant deux demi-bras de commutation supérieur et inférieur en série, le demi-bras de commutation supérieur étant relié électriquement à la première borne et le demi-bras de commutation inférieur étant relié électriquement à la deuxième borne, les demi-bras de commutation comportant chacun au moins un commutateur à semi-conducteur, chaque commutateur comprenant une électrode de commande et deux électrodes de conduction,
caractérisé en ce qu'il comporte un dispositif de détection de court-circuit selon l'une quelconque des revendications précédentes avec chaque paire de bornes de mesure connectée à un demi-bras de commutation respectif, chaque paire de borne de mesure étant connectée aux bornes d'une inductance parasite en série avec l'une des électrodes de conduction du au moins un commutateur du demi-bras de commutation respectif, et en ce que pour chaque paire de borne de mesure, la quatrième borne est positionnée entre la troisième borne et la première borne.

Suivant certains modes de réalisation, le dispositif de puissance comporte l'une ou plusieurs des caractéristiques suivantes :
- les électrodes de conduction du au moins un commutateur du demi-bras de commutation supérieur comprennent une première électrode de conduction reliée électriquement à la première borne et une deuxième électrode de conduction reliée électriquement à un nœud entre les deux demi-bras de commutation, et les électrodes de conduction du au moins un commutateur du demi-bras de commutation inférieur comprennent une première électrode de conduction reliée électriquement au nœud entre les deux demi-bras de commutation et une deuxième électrode de conduction reliée électriquement à la deuxième borne,
- chaque demi-bras de commutation comporte un unique commutateur (18), et
- les paires de bornes de mesure sont connectées respectivement aux bornes d'une inductance parasite située entre le commutateur du demi-bras de commutation supérieur et la première borne, et d'une inductance parasite située entre le commutateur du demi-bras de commutation inférieur et la deuxième borne.

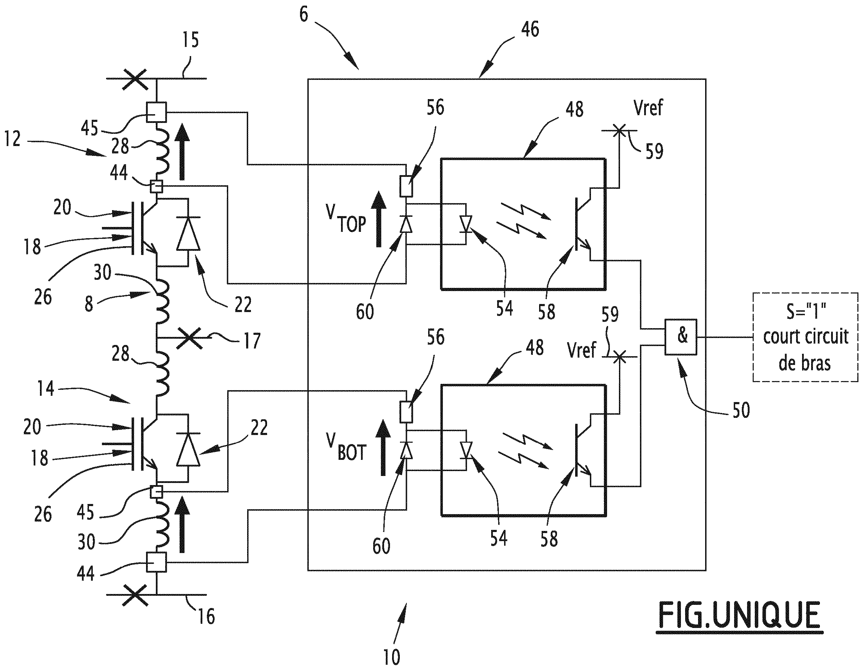

L'invention sera mieux comprise à la lecture de la description qui va suivre, donnée uniquement à titre d'exemple, se référant à la figure 1 qui est une vue schématique d'un dispositif de détection de court-circuit connecté sur un bras de commutation.

***[******Fig 1******]*** La figure 1 comprend un dispositif de puissance 6 tel qu'un onduleur ou en variante, un circuit d'alimentation. Celui-ci comporte un bras de commutation 8 et un dispositif de détection d'un court-circuit 10 dans ce bras de commutation 8.

Le bras de commutation 8 comporte deux demi-bras de commutation en série : un demi-bras de commutation supérieur 12 et un demi-bras de commutation inférieur 14. Ces demi-bras de commutation 12 et 14 sont connectés en série entre une première borne 15 et une deuxième borne 16 d'alimentation en tension, le demi-bras de commutation supérieur 12 étant relié électriquement à la première borne 15 et le demi-bras de commutation inférieur 14 étant relié à la deuxième borne 16. Ces première et deuxième bornes 15 et 16 sont reliées à des sources de tension continue, la tension délivrée à la première borne 15 étant supérieure à la tension délivrée à la deuxième borne 16.

Le bras de commutation 8 comprend aussi une sortie 17 connectée à un nœud entre les deux demi-bras 12 et 14 et délivrant une énergie électrique alternative à une phase du dispositif de puissance 6.

Chaque demi-bras de commutation 12 ou 14 comprend au moins un commutateur 18 configuré pour contrôler le passage du courant dans le demi-bras de commutation respectif. Chaque demi-bras de commutation 12 ou 14 comprend de préférence un unique commutateur 18, comme illustré dans l'exemple.

Chaque commutateur 18 comprend une électrode de commande et deux électrodes de conduction. Les électrodes de conduction du commutateur 18 du demi-bras de commutation supérieur 12 comprennent une première électrode de conduction reliée électriquement à la première borne 15 et une deuxième électrode de conduction reliée électriquement à la sortie 17, et les électrodes de conduction du commutateur 18 du demi-bras de commutation inférieur 14 comprennent une première électrode de conduction reliée électriquement à la sortie 17 et une deuxième électrode de conduction reliée électriquement à la deuxième borne 16.

Les commutateurs 18 sont par exemple formés d'un transistor bipolaire à grille isolée 20, également appelé IGBT (de l'anglais *Insulated Gate Bipolar Transistor*) comprenant une grille, un émetteur et un collecteur, et d'une diode 22 connectée en antiparallèle au transistor 20. Dans ce cas, l'électrode de commande d'un commutateur 18 correspond à la grille de l'IGBT 20 correspondant, la première électrode de conduction correspond au collecteur et la deuxième électrode de conduction correspond à l'émetteur. Chaque commutateur 18 comprend comme connu en soi, un transistor parfait 26, une inductance parasite 28 au collecteur du transistor 26 et une inductance parasite 30 à l'émetteur du transistor 26.

Comme connu en soi, les grilles des transistors 26 sont reliées à une unité de commande propre à commuter les transistors 26 alternativement entre un état passant et un état non passant.

Le dispositif de détection de court-circuit 10 comprend deux paires de bornes de mesure 44, 45 et une unité de traitement d'information 46 connectée en entrée aux paires de bornes de mesure 44, 45 et ayant une sortie logique propre à fournir un signal indiquant la détection d'un court-circuit dans le bras de commutation 8.

Les paires de bornes de mesure 44, 45 sont respectivement connectées aux demi-bras de commutation 12 et 14. Chaque paire de bornes de mesure 44, 45 est connectée aux bornes d'une inductance parasite 28 ou 30 d'un commutateur 18 d'un demi-bras de commutation respectif 12, 14. Chaque paire de bornes de mesure 44, 45 possède une troisième borne 44 et une quatrième borne 45, avec la quatrième borne 45 positionnée en amont de la troisième borne 44 par rapport à la première borne 15, c'est-à-dire entre la première borne 15 et la troisième borne 44.

De préférence, les paires de bornes de mesure 44, 45 sont connectées respectivement aux bornes des inductances parasites les plus proches des première et deuxième bornes 15 et 16. De cette façon, elles sont connectées aux inductances parasites reliées à la première borne 15 et la deuxième borne 16, c'est-à-dire aux bornes de l'inductance parasite au collecteur 28 de l'unique commutateur 18 du demi-bras de commutation supérieur 12, et aux bornes de l'inductance parasite à l'émetteur 30 de l'unique commutateur 18 du demi-bras de commutation inférieur 14.

L'unité de traitement 46 comprend pour chaque paire de bornes de mesure 44, 45, un module de détection 48 du signe d'une tension mesurée aux bornes de mesure 44, 45, et un module de comparaison 50 en entrée duquel sont reliés les sorties des modules de détection 48.

Le module de détection 48 comprend par exemple un optocoupleur configuré pour délivrer un signal représentatif du signe de la différence entre le potentiel de la quatrième borne 45 et le potentiel de la troisième borne 44. Il comporte une diode électroluminescente 54 et un capteur optique 58. Dans l'exemple décrit, le capteur optique 58 comprend un phototransistor.

La diode électroluminescente 54 est connectée de façon à ce qu'elle soit passante lorsque la tension mesurée V_{TOP} ou V_{BOT} dans le demi-bras respectif 12 ou 14 est positive, V_{TOP} et V_{BOT} correspondant aux différences entre le potentiel de la borne 45 et le potentiel de la borne 44 des demi-bras respectifs 12 et 14.

Une résistance 56 est connectée en série aux bornes de mesure 44, 45 afin de limiter le courant à travers le module 48.

Le capteur optique 58 est propre à détecter une onde lumineuse issue de la diode électroluminescente 54, par exemple via une fibre optique. La sortie du capteur optique 58 est propre à fournir un signal représentatif du signe de la tension mesurée aux bornes de mesure 44, 45.

Dans l'exemple décrit, le phototransistor est passant lorsqu'il reçoit une onde lumineuse issue de la diode électroluminescente 54 et bloqué dans le cas contraire. Il est alimenté au collecteur par un niveau logique Vref, par exemple via un rail d'alimentation continue 59 et délivre un signal représentatif du signe de la tension mesurée aux bornes de mesure 44, 45 à l'émetteur.

En complément facultatif, une diode 60 est connectée tête-bêche avec la diode électroluminescente 54.

Le module de comparaison 50 est un opérateur logique « ET ». Le module de comparaison 50 est connecté en entrée à la sortie des deux modules de détection 48. Il est propre à délivrer le signal indiquant la détection d'un court-circuit à la sortie logique de l'unité de traitement 46, qui est aussi la sortie du dispositif de détection 10, en fonction des signaux récupérés en entrée, le court-circuit étant détecté seulement lorsque les deux tensions mesurées V_{TOP} et V_{BOT} aux bornes de mesure 44, 45 sont détectées positives par les modules de détection 48.

Le module de détection 10 détecte si les tensions dans les inductances parasites 28 et 30, auxquelles sont connectées les paires de bornes de mesure 44, 45, sont toutes les deux positives, c'est-à-dire, si les courants circulant dans les demi-bras de commutation 12 et 14, pris de la première borne 15 vers la deuxième borne 16, sont tous les deux croissants.

En fonctionnement normal, on observe deux cas de fonctionnement. Les courants décrits par la suite sont tous considérés avec un sens de circulation de la première borne 15 vers la deuxième borne 16.

Un premier cas de fonctionnement normal correspond à l'amorçage du transistor 20 dans le demi-bras supérieur 12. Initialement, le transistor 20 dans le demi-bras supérieur 12 est bloqué et le transistor 20 dans le demi-bras inférieur 14 est passant. Le courant est constant et non nul dans le demi-bras inférieur 14 et est nul dans le demi-bras supérieur 12. Les tensions V_{TOP} et V_{BOT} sont alors nulles. Lors de la commutation, le transistor 20 est amorcé dans le demi-bras supérieur 12 et le transistor 20 est bloqué dans le demi-bras inférieur 14. Le courant dans le demi-bras supérieur 12 augmente et le courant dans le demi-bras inférieur 14 diminue en même temps jusqu'à devenir nul. Les tensions V_{TOP} et V_{BOT} prennent alors respectivement des valeurs positives et négatives. A la fin de l'amorçage du transistor 20 dans le demi-bras supérieur 12, le courant circule et est constant dans le demi-bras supérieur 12 et le courant est nul dans le demi-bras inférieur 14. Les tensions V_{TOP} et V_{BOT} sont alors nulles.

Un deuxième cas de fonctionnement normal correspond au blocage du transistor 20 dans le demi-bras supérieur 12. Initialement, le transistor 20 dans le demi-bras supérieur 12 est passant et le transistor 20 dans le demi-bras inférieur 14 est bloqué. Le courant est constant et non nul dans le demi-bras supérieur 12 et est nul dans le demi-bras inférieur 14. Les tensions V_{TOP} et V_{BOT} sont alors nulles. Lors de la commutation, le transistor 20 est bloqué dans le demi-bras supérieur 12 et le transistor 20 est amorcé dans le demi-bras inférieur 14. Le courant dans le demi-bras inférieur 14 augmente et le courant dans le demi-bras supérieur 12 diminue en même temps jusqu'à devenir nul. Les tensions V_{TOP} et V_{BOT} prennent alors respectivement des valeurs négatives et positives. A la fin du blocage du transistor 20 dans le demi-bras supérieur 12, le courant circule et est constant dans le demi-bras inférieur 14 et le courant est nul dans le demi-bras supérieur 12. Les tensions V_{TOP} et V_{BOT} sont alors nulles.

Dans ces deux cas de fonctionnement normal, le cas où les tensions V_{TOP} et V_{BOT} sont toutes les deux positives n'est jamais détecté et le module de détection 10 donne en sortie un niveau logique "0" qui indique qu'il ne détecte pas de court-circuit dans le bras de commutation 8.

Lors de l'apparition d'un court-circuit dans le bras de commutation 8, le courant circulant dans les demi-bras de commutation 12 et 14, depuis la première borne 15 jusqu'à la deuxième borne 16, croît rapidement. Le dispositif de détection 10 détecte que les tensions V_{TOP} et V_{BOT} sont toutes les deux positives et donne en sortie un niveau logique "1" qui indique qu'un court-circuit dans le bras de commutation 8 est détecté.

Le module de détection 10 permet donc de détecter un court-circuit en se basant non pas sur un dépassement de seuil, mais sur la détection d'un état logique.

La diode 60 connectée tête-bêche avec la diode électroluminescente 54 permet de protéger la diode électroluminescente 54 lorsque la tension V_{TOP} ou V_{BOT} change de signe.

La connexion des bornes de mesures 44, 45 aux bornes des inductances les plus proches des première et deuxième bornes 15 et 16 permet d'avoir une mesure de la tension plus précise, car les tensions aux première et deuxième bornes sont constante.

On conçoit alors que le dispositif de détection de court-circuit 10 permet alors de détecter un éventuel court-circuit dans un bras de commutation 8 avec une réalisation simple, notamment en utilisant des opérations logiques.

## Revendications

1. Dispositif de détection (10) de court-circuit dans un bras de commutation (8), le bras de commutation étant destiné à être positionné entre une première borne (15) et une deuxième borne (16) d'alimentation en tension, le potentiel de la première borne (15) étant propre à être supérieur au potentiel de la deuxième borne (16), le bras de commutation comprenant deux demi-bras de commutation supérieur (12) et inférieur (14) en série, le demi-bras de commutation supérieur (12) étant relié électriquement à la première borne (15) et le demi-bras de commutation inférieur (14) étant relié électriquement à la deuxième borne (16), les demi-bras de commutation (12, 14) comportant chacun au moins un commutateur (18) à semi-conducteur, chaque commutateur (18) comprenant une électrode de commande et deux électrodes de conduction,
le dispositif de détection de court-circuit (10) comprenant :
- pour chaque demi-bras de commutation, une paire de bornes de mesure (44, 45), comprenant une troisième borne (44) et une quatrième borne (45), configurées pour être connectées aux bornes d'une inductance parasite (28, 30) en série avec l'une des électrodes de conduction du au moins un commutateur (18) dudit demi-bras de commutation (12, 14), la quatrième borne (45) étant destinée à être positionnée entre la troisième borne (44) et la première borne (15), et
- une unité de traitement d'information (46) connectée en entrée aux paires de bornes de mesure (44, 45) et ayant une sortie logique propre à fournir un signal indiquant la détection d'un court-circuit dans le bras de commutation (8),
**caractérisé en ce que** l'unité de traitement (46) comporte :
- pour chaque paire de bornes de mesure (44, 45), un module de détection (48) configuré pour transmettre en sortie un signal de sortie représentatif du signe de la différence entre le potentiel de la quatrième borne (45) et le potentiel de la troisième borne (44), et
- un module de comparaison (50) propre à fournir via la sortie logique le signal indiquant la détection d'un court-circuit, seulement lorsque les signaux de sortie transmis par les deux modules de détection sont chacun représentatifs d'un signe positif.

2. Dispositif de détection de court-circuit (10) selon la revendication 1, **caractérisé en ce que** chaque module de détection (48) comprend un optocoupleur.

3. Dispositif de détection de court-circuit (10) selon la revendication 2, **caractérisé en ce que** chaque optocoupleur comprend une diode électroluminescente (54) connectée aux bornes de mesure (44, 45) et un capteur optique (58) dont la sortie est propre à fournir le signal de sortie représentatif du signe de la différence entre le potentiel de la quatrième borne et le potentiel de la troisième borne.

4. Dispositif de détection de court-circuit (10) selon la revendication 3, **caractérisé en ce que** la diode électroluminescente est configurée pour émettre une onde lumineuse lorsque le signe de la différence entre le potentiel de la quatrième borne et le potentiel de la troisième borne est positif et chaque capteur optique (58) comprend un phototransistor configuré pour être passant seulement lorsqu'il détecte une onde lumineuse issue de la diode électroluminescente (54).

5. Dispositif de détection de court-circuit (10) selon la revendication 3 ou 4, **caractérisé en ce qu'**une diode (60) est connectée tête-bêche avec la diode électroluminescente (54).

6. Dispositif de détection de court-circuit (10) selon l'une quelconque des revendications précédentes, **caractérisé en ce que** le module de comparaison (50) est une porte logique ET.

7. Dispositif de puissance (6) comportant au moins un bras de commutation (8), le bras de commutation étant positionné entre une première borne (15) et une deuxième borne (16) d'alimentation en tension, le potentiel de la première borne (15) étant supérieur au potentiel de la deuxième borne (16), le bras de commutation (8) comprenant deux demi-bras de commutation supérieur (12) et inférieur (14) en série, le demi-bras de commutation supérieur (12) étant relié électriquement à la première borne (15) et le demi-bras de commutation inférieur (14) étant relié électriquement à la deuxième borne (16), les demi-bras de commutation (12, 14) comportant chacun au moins un commutateur (18) à semi-conducteur, chaque commutateur comprenant une électrode de commande et deux électrodes de conduction, **caractérisé en ce qu'**il comporte un dispositif de détection de court-circuit (10) selon l'une quelconque des revendications précédentes avec chaque paire de bornes de mesure (44, 45) connectée à un demi-bras de commutation (12, 14) respectif, chaque paire de borne de mesure (44, 45) étant connectée aux bornes d'une inductance parasite (28, 30) en série avec l'une des électrodes de conduction du au moins un commutateur (18) du demi-bras de commutation (12, 14) respectif, et **en ce que** pour chaque paire de borne de mesure (44, 45), la quatrième borne (45) est positionnée entre la troisième borne (44) et la première borne (15).

8. Dispositif de puissance (10) selon la revendication 7, **caractérisé en ce que** les électrodes de conduction du au moins un commutateur (18) du demi-bras de commutation supérieur (12) comprennent une première électrode de conduction reliée électriquement à la première borne (15) et une deuxième électrode de conduction reliée électriquement à un nœud entre les deux demi-bras de commutation (12, 14), et **en ce que** les électrodes de conduction du au moins un commutateur (18) du demi-bras de commutation inférieur (14) comprennent une première électrode de conduction reliée électriquement au nœud entre les deux demi-bras de commutation (12, 14) et une deuxième électrode de conduction reliée électriquement à la deuxième borne (16).

9. Dispositif de puissance (10) selon la revendication 7 ou 8, **caractérisé en ce que** chaque demi-bras de commutation (12, 14) comporte un unique commutateur (18).

10. Dispositif de puissance (10) selon la revendication 9, **caractérisé en ce que** les paires de bornes de mesure (44) sont connectées respectivement aux bornes d'une inductance parasite (28) située entre le commutateur (18) du demi-bras de commutation supérieur (12) et la première borne (15), et d'une inductance parasite (30) située entre le commutateur (18) du demi-bras de commutation inférieur (14) et la deuxième borne (16).

## Patentansprüche

1. Vorrichtung (10) zum Erfassen eines Kurzschlusses in einem Schaltzweig (8), wobei der Schaltzweig dazu bestimmt ist, zwischen einem ersten Anschluss (15) und einem zweiten Anschluss (16) einer Spannungsversorgung positioniert zu sein, wobei das Potential des ersten Anschlusses (15) höher sein kann als das Potential des zweiten Anschlusses (16), wobei der Schaltzweig einen oberen (12) und einen unteren (14) Schalthalbzweig in Reihe umfasst und der obere Schalthalbzweig (12) elektrisch mit dem ersten Anschluss (15) und der untere Schalthalbzweig (14) elektrisch mit dem zweiten Anschluss (16) verbunden sind, wobei die Schalthalbzweige (12, 14) jeweils mindestens einen Halbleiterschalter (18) umfassen und jeder Schalter (18) eine Steuerelektrode und zwei Leitungselektroden umfasst,
wobei die Vorrichtung (10) zum Erfassen eines Kurzschlusses umfasst:
- für jeden Schalthalbzweig ein Paar von Messanschlüssen (44, 45), das einen dritten Anschluss (44) und einen vierte Anschluss (45) umfasst und ausgebildet ist, mit den Anschlüssen einer parasitären Induktivität (28, 30) in Reihe mit einer der Leitungselektroden des mindestens einen Schalters (18) des Schalthalbzweigs (12, 14) verbunden zu sein, wobei der vierte Anschluss (45) dazu bestimmt ist, zwischen dem dritten Anschluss (44) und dem ersten Anschluss (15) positioniert zu werden, und
- eine Informationsverarbeitungseinheit (46), die am Eingang mit dem Paar von Messanschlüssen (44, 45) verbunden ist und einen logischen Ausgang aufweist, der geeignet ist, ein Signal zu liefern, das die Erfassung eines Kurzschlusses in dem Schaltzweig (8) anzeigt,
**dadurch gekennzeichnet, dass** die Verarbeitungseinheit (46) umfasst:
- für jedes Paar von Messanschlüssen (44, 45) ein Erfassungsmodul (48), das ausgebildet ist, ausgangsseitig ein Ausgangssignal zu liefern, das für das Vorzeichen der Differenz zwischen dem Potential des vierten Anschlusses (45) und dem Potential des dritten Anschlusses (44) repräsentativ ist, und
- ein Vergleichsmodul (50), das geeignet ist, über den logischen Ausgang nur dann das Signal zu liefern, das die Erfassung eines Kurzschlusses anzeigt, wenn die von den beiden Erfassungsmodulen übertragenen Ausgangssignale jeweils für ein positives Vorzeichen repräsentativ sind.

2. Vorrichtung (10) zum Erfassen eines Kurzschlusses nach Anspruch 1, **dadurch gekennzeichnet, dass** jedes Erfassungsmodul (48) einen Optokoppler umfasst.

3. Vorrichtung (10) zum Erfassen eines Kurzschlusses nach Anspruch 2, **dadurch gekennzeichnet, dass** jeder Optokoppler eine mit den Messanschlüssen (44, 45) verbundene Leuchtdiode (54) und einen optischen Sensor (58) umfasst, dessen Ausgang geeignet ist, das für das Vorzeichen der Differenz zwischen dem Potential des vierten Anschlusses und dem Potential des dritten Anschlusses repräsentative Ausgangssignal zu liefern.

4. Vorrichtung (10) zum Erfassen eines Kurzschlusses nach Anspruch 3, **dadurch gekennzeichnet, dass** die Leuchtdiode ausgebildet ist, eine Lichtwelle zu senden, wenn das Vorzeichen der Differenz zwischen dem Potential des vierten Anschlusses und dem Potential des dritten Anschlusses positiv ist, und jeder optische Sensor (58) einen Fototransistor umfasst, der ausgebildet ist, nur dann zu leiten, wenn er eine Lichtwelle von der Leuchtdiode (54) detektiert.

5. Vorrichtung (10) zum Erfassen eines Kurzschlusses nach Anspruch 3 oder 4, **dadurch gekennzeichnet, dass** eine Diode (60) antiparallel zu der Leuchtdiode (54) geschaltet ist.

6. Vorrichtung (10) zum Erfassen eines Kurzschlusses nach einem der vorhergehenden Ansprüche, **dadurch gekennzeichnet, dass** das Vergleichsmodul (50) ein UND-Logikgatter ist.

7. Leistungsvorrichtung (6) mit mindestens einem Schaltzweig (8), der zwischen einem ersten Anschluss (15) und einem zweiten Anschluss (16) einer Spannungsversorgung angeordnet ist, wobei das Potential des ersten Anschlusses (15) höher ist als das Potential des zweiten Anschlusses (16), wobei der Schaltzweig (8) einen oberen (12) und einen in Reihe geschalteten unteren (14) Schalthalbzweig umfasst und der obere Schalthalbzweig (12) elektrisch mit dem ersten Anschluss (15) und der untere Schalthalbzweig (14) elektrisch mit dem zweiten Anschluss (16) verbunden sind, wobei die Schalthalbzweige (12, 14) jeweils mindestens einen Halbleiterschalter (18) umfassen, wobei jeder Schalter eine Steuerelektrode und zwei Leitungselektroden umfasst, **dadurch gekennzeichnet, dass** sie eine Vorrichtung (10) zum Erfassen eines Kurzschlusses nach einem der vorhergehenden Ansprüche umfasst, wobei jedes Paar von Messanschlüssen (44, 45) mit einem jeweiligen Schalthalbzweig (12, 14) verbunden ist und jedes Paar von Messanschlüssen (44, 45) mit den Anschlüssen einer parasitären Induktivität (28, 30) in Reihe mit einer der Leitungselektroden des mindestens einen Schalters (18) des jeweiligen Schalthalbzweiges (12, 14) verbunden ist, und dass für jedes Paar von Messanschlüssen (44, 45) der vierte Anschluss (45) zwischen dem dritten Anschluss (44) und dem ersten Anschluss (15) angeordnet ist.

8. Leistungsvorrichtung (10) nach Anspruch 7, **dadurch gekennzeichnet, dass** die Leitungselektroden des mindestens einen Schalters (18) des oberen Schalthalbzweiges (12) eine erste Leitungselektrode, die elektrisch mit dem ersten Anschluss (15) verbunden ist, und eine zweite Leitungselektrode, die elektrisch mit einem Knotenpunkt zwischen den beiden Schalthalbzweigen (12, 14) verbunden ist, umfassen, und dass die Leitungselektroden des mindestens einen Schalters (18) des unteren Schalthalbzweiges (14) eine erste Leitungselektrode, die elektrisch mit dem Knotenpunkt zwischen den beiden Schalthalbzweigen (12, 14) verbunden ist, und eine zweite Leitungselektrode, die elektrisch mit dem zweiten Anschluss (16) verbunden ist, umfassen.

9. Leistungsvorrichtung (10) nach Anspruch 7 oder 8, **dadurch gekennzeichnet, dass** jeder Schalthalbzweig (12, 14) einen einzigen Schalter (18) aufweist.

10. Leistungsvorrichtung (10) nach Anspruch 9, **dadurch gekennzeichnet, dass** die Paare von Messanschlüssen (44) jeweils mit den Anschlüssen einer parasitären Induktivität (28), die zwischen dem Schalter (18) des oberen Schalthalbzweigs (12) und dem ersten Anschluss (15) liegt, und einer parasitären Induktivität (30), die zwischen dem Schalter (18) des unteren Schalthalbzweigs (14) und dem zweiten Anschluss (16) liegt, verbunden sind.

## Claims

1. A short-circuit detection device (10) in a switching arm (8), the switching arm being positioned between a first terminal (15) and a second voltage supply terminal (16), the potential of the first terminal (15) being suitable for being greater than the potential of the second terminal (16), the switching arm comprising two higher (12) and lower (14) switching half-arms in series, the higher switching half-arm (12) being electrically connected to the first terminal (15) and the lower switching half-arm (14) being electrically connected to the second terminal (16), the switching half-arms (12, 14) each including at least one semiconductor switch (18), each switch (18) comprising a control electrode and two conduction electrodes,
the short-circuit detection device (10) comprising:
- for each switching half-arm, a pair of measuring terminals (44, 45), comprising a third terminal (44) and a fourth terminal (45), configured to be connected to the terminals of a stray inductance (28, 30) in series with one of the conduction electrodes of the at least one switch (18) of said switching half-arm (12, 14), the fourth terminal (45) being suitable for being positioned between the third terminal (44) and the first terminal (15), and
- an information processing unit (46) connected as input to the pairs of measuring terminals (44, 45) and having a logic output able to supply a signal indicating the detection of a short-circuit in the switching arm (8),
**characterized in that** the processing unit (46) includes:
- for each pair of measuring terminals (44, 45), a detection module (48) configured to send, as output, an output signal representative of the sign of the difference between the potential of the fourth terminal (45) and the potential of the third terminal (44), and
- a comparison module (50) capable of supplying, via the logic output, the signal indicating the detection of a short-circuit, only when the output signals sent by the two detection modules are each representative of a positive sign.

2. The short-circuit detection device (10) according to claim 1, **characterized in that** each detection module (48) comprises an optocoupler.

3. The short-circuit detection device (10) according to claim 2, **characterized in that** each optocoupler comprises a light-emitting diode (54) connected to the measuring terminals (44, 45) and an optical sensor (58), the output of which is able to supply the output signal representative of the sign of the difference between the potential of the fourth terminal and the potential of the third terminal.

4. The short-circuit detection device (10) according to claim 3, **characterized in that** the light-emitting diode is configured to emit a light wave when the sign of the difference between the potential of the fourth terminal and the potential of the third terminal is positive and each optical sensor (58) comprises a phototransistor configured to be on only when it detects a light wave coming from the light-emitting diode (54).

5. The short-circuit detection device (10) according to claim 3 or 4, **characterized in that** diode (60) is connected head-to-tail with the light-emitting diode (54).

6. The short-circuit detection device (10) according to any one of the preceding claims, **characterized in that** the comparison module (50) is an AND logic gate.

7. A power device (6) including at least one switching arm (8), the switching arm being positioned between a first terminal (15) and a second voltage supply terminal (16), the potential of the first terminal (15) being greater than the potential of the second terminal (16), the switching arm (8) comprising two higher (12) and lower (14) switching half-arms in series, the higher switching half-arm (12) being electrically connected to the first terminal (15) and the lower switching half-arm (14) being electrically connected to the second terminal (16), the switching half-arms (12, 14) each including at least one semiconductor switch (18), each switch comprising a control electrode and two conduction electrodes, **characterized in that** it includes a short-circuit detection device (10) according to any one of the preceding claims with each pair of measuring terminals (44, 45) connected to a respective switching half-arm (12, 14), each pair of measuring terminals (44, 45) being connected to the terminals of a stray inductances (28, 30) in series with one of the conduction electrodes of at least one switch (18) of the respective switching half-arm (12, 14), and **in that** for each pair of measuring terminals (44, 45), the fourth terminal (45) is positioned between the third terminal (44) and the first terminal (15).

8. The power device (10) according to claim 7, **characterized in that** the conduction electrodes of the at least one switch (18) of the upper switching half-arm (12) comprise a first conduction electrode electrically connected to the first terminal (15) and a second conduction electrode electrically connected to a node among the two switching half-arms (12, 14), and **in that** the conduction electrodes of the at least one switch (18) of the lower switching half-arm (14) comprise a first conduction electrode electrically connected to the node among the two switching half-arms (12, 14) and a second conduction electrode electrically connected to the second terminal (16).

9. The power device (10) according to claim 7 or 8, **characterized in that** each switching half-arm (12, 14) includes a single switch (18).

10. The power device (10) according to claim 9, **characterized in that** the pairs of measuring terminals (44) are respectively connected to the terminals of a stray inductance (28) located between the switch (18) of the upper switching half-arm (12) and the first terminal (15), and a stray inductance (30) located between the switch (18) of the lower switching half-arm (14) and the second terminal (16).
